# EUROPÄISCHE PATENTSCHRIFT

(11) **EP 0 511 482 B1**
(45) Veröffentlichungstag und Bekanntmachung des Hinweises auf die Patenterteilung: **04.10.1995**
(21) Anmeldenummer: 92104340.2
(22) Anmeldetag: 13.03.1992
(51) Int. Cl.: G01R 11/04

(54) **Verfahren zum Ausrüsten von Elektrizitätszählern mit je einem externen Modul und Zwischenstück zur Durchführung des Verfahrens**
Method of providing electricity meters with an external module and adaptor for carrying out this method
Procédé pour équiper des compteurs d'électricité avec un module externe et adaptateur pour la mise en oeuvre de ce procédé

(30) Priorität: 30.04.1991 CH 1298/91
(43) Veröffentlichungstag der Anmeldung: 04.11.1992
(73) Patentinhaber: Landis & Gyr Technology Innovation AG, 6301 Zug (CH)
(72) Erfinder: Gertschnig, Kurt, CH-6414 Oberarth (CH); Antonovic, Dragan, CH-6020 Emmenbrücke (CH)

(56) Entgegenhaltungen:
- EP-A- 0 156 981
- DE-A- 2 630 608
- FR-A- 2 211 653
- US-A- 4 368 943

## Beschreibung

Die Erfindung bezieht sich auf ein Verfahren zum Ausrüsten von Elektrizitätszahlern einer Vielzahl von Elektrizitätszähler-Varianten mit je einem nach dem Ausrüsten auf einen, Zwischenstück angeordneten externen Modul gemäss dem Oberbegriff des Anspruchs 1 und auf ein Zwischenstück zum Ausrüsten eines Elektrizitäts zählers mittels des Verfahrens gemäss dem Oberbegriff des Anspruchs 6 und geht von EP-A-0 156 981 aus.

Das externe Modul besteht mindestens teilweise aus elektronischen Schaltungen und ist z. B. ein Tarifgerät, ein Maximum-Zählwerk, ein Rundsteuerungs-Empfänger, ein anderes zum Elektrizitätszähler elektrisch passendes Hilfsgerät oder eine Kombination mindestens eines Teils dieser Geräte.

Die Elektrizitätszähler sind vorzugsweise Ferrari-Zähler, die, einmal abgesehen von den leicht austauschbaren Lagern, als anspruchsvolle, teure und in der Qualität hochstehende Messgeräte eine weit über derjenigen von Elektronikschaltungen liegende Lebensdauer aufweisen. Die letzteren weisen bekanntlich nur eine beschränkte Lebensdauer in der Grössenordnung von höchstens 15 Jahren auf.

Es besteht heutzutage, z. B. aus Gründen des Umweltschutzes, seitens der Elektrizitätswerke ein grosses Bedürfnis, nur mehr Elektrizitätszähler einzusetzen, die mindestens teilweise mit elektronischen Schaltungen ausgerüstet sind. Die letzteren dienen unter anderem hauptsächlich dazu, ausgehend von Messwerten des Elektrizitätszählers, einen momentanen Tarif, einen momentanen Energieverbrauch, eine saisonale Energieerfassung, ein momentanes Maximum, eine Anzahl Kumulierungen von Energiewerten mit den zugehörigen Monaten, eine seit einer letzten Kumulierung oder Rückstellung verflossene Zeit und/oder weitere Werte zu ermitteln oder anzuzeigen. Sie können auch dazu dienen, den Elektrizitätszähler z. B. von Hoch- auf Niedertarif umzuschalten, und werden oft als Tarifgeräte, Maximum-Zählwerke, Rundsteuerempfänger, usw. bezeichnet.

Der Ersatz der vielen alten, bereits bei den Kunden montierten Elektrizitätszählern verlangt jedoch seitens der Elektrizitätswerke hohe Investitionen und dies, obwohl von der Qualität und der Lebensdauer her die ausgetauschten alten Elektrizitätszähler durchaus noch in Ordnung und brauchbar sind, so dass die neuen Investitionen von der Sache her im Grunde genommen gar nicht unbedingt erforderlich und sogar teilweise kontraproduktiv sind, da die elektronischen Schaltungen, wie erwähnt, nur eine beschränkte Lebensdauer besitzen und spätestens nach Ablauf dieser Zeit ausgetauscht werden müssen, falls dieses nicht bereits früher zur Behebung von Defekten erforderlich war.

Aus der PCT-Offenlegungsschrift WO 86/04994 ist ein externes Modul in Gestalt eines Tarifgerätes und/oder eines Rundsteuerungs-Empfängers bekannt, welches steckbar auf eine Klemmenabdeckung eines Ferrari-Zählers montierbar ist, wobei die Abdeckung Abmessungen sowie eine in einer ganz bestimmten Weise ausgebildete Gestalt besitzt, die alle auf diejenigen des zugehörigen externen Moduls angepasst sind. Das letztere ist somit nur auf solche Elektrizitätszähler montierbar, die mindestens annähernd eine derartig dimensionierte und ausgebildete Abdeckung aufweisen, was bei den wenigsten, in der Vergangenheit im Handel befindlich gewesenen und noch jetzt bei Kunden montierten Elektrizitätszählern der Fall ist. Falls ein bestimmtes, in seiner äusseren Gestalt und Abmessung festgelegtes Modul auf die letzteren montiert werden soll, ist somit mindestens ein Austausch der Abdeckung erforderlich, was in den meisten Fällen, wenn überhaupt, nur mit grössten Schwierigkeiten möglich und in jedem Fall ausgesprochen teuer und unrentabel ist.

Ein Verfahren und ein Zwischenstück der eingangs genannten Art ist aus der EP-A-0 156 981 bekannt, in der ein Zusatzgerät für Elektrizitätszähler erwähnt wird, welches aus einem Oberteil und einem Sockel besteht. Der letztere weist zur elektrischen Verbindung des Zusatzgerätes mit dem Elektrizitätszähler eine Klemmleiste und eine damit elektrisch verbundene Buchsenleiste auf. Das Oberteil enthält unter anderem eine Steckerleiste, die bei aufgesetztem Oberteil in die Buchsenleiste gesteckt ist. Durch diesen Aufbau des Zusatzgerätes wird laut Aufgabenstellung eine Montage und ein Austausch des Zusatzgerätes vereinfacht und ein Einsatz auch fuhr nicht speziell dafür ausgerüstete Elektrizitätszähler, z. B für beliebige Norm-Elektrizitätszähler, möglich. Der Sockel ist anstelle des Elektrizitätszähler-Klemmendeckels an den dafür vorgesehenen Schraubbuchsen des Elektrizitätszähler-Klemmenblocks befestigt, wobei die Befestigung am letzteren mittels zweier Laschen erfolgt, die austauschbar am Sockel befestigt sind. Durch einen Austausch der Laschen kann der Sockel an unterschiedliche Befestigungsmasse der Elektrizitätszähler-Klemmendeckel angepasst werden, so dass für unterschiedliche Elektrizitätszähler-Ausführungen ein einheitliches Gehäuse verwendet werden kann. Der Sockel ist kastenförmig ausgebildet und besitzt auf seiner Unterseite drei Leerräume. Nach der Montage des Sockels ragt der Elektrizitätszähler-Klemmenblock in einem der drei Leerräume hinein. Ein unterer Bereich einer Aussenwand des Oberteils umgreift den Sockel. Das Gehäuse ist so ausgeführt, dass es als Ersatz für den Elektrizitätszähler-Klemmendeckel den Elektrizitätszähler-Klemmenblock überdeckt. Der Sockel wird unabhängig vom Oberteil am vorgesehenen Einbauort montiert. Nach der Montage des Sockels wird am Einbauplatz des Zusatzgerätes eine komplette Verdrahtung zum Elektrizitätszähler von geschultem Fachpersonal durchgeführt, worauf das Zusatzgerät nur noch aufgesteckt werden muss, was durch nicht speziell ausgebildetes Hilfspersonal erfolgen kann. Es ist jedoch nicht erkennbar, wie eine Einhaltung von zusätzlichen Sicherheitsvorschriften, wie z. B. das Erzielen von Hermetizität, erreicht werden kann. Letzteres erfordert nämlich eine Bearbeitung des Klemmenblocks, was vor Ort und ohne Demontieren des gesamten Elektrizitätszählers kaum möglich ist und selbst in Werkstätten oft nur nach einem Öffnen des Gehäusedeckels und damit einer Zerstörung der amtlichen Eichplombe stattfinden kann, was alles unpraktisch ist, Verunreinigungs-Gefahren für die feinmechanischen Teile der Ferrari-Zähler in sich birgt sowie eine teure und zeitraubende amtliche Nacheichung erfordert. Der Sockel des Zusatzgerätes erfordert ausserdem unterhalb des Klemmblocks zusätzlichen Platz, der in Altbauwohnungen unterhalb bereits vorhandener Alt-Elektrizitätszähler oft nicht vorhanden ist.

Der Erfindung liegt die Aufgabe zugrunde, das bekannte Verfahren und das bekannte Zwischenstück so zu verbessern, dass sie für eine Vielzahl von in der Regel unterschiedlichen Elektrizitätszähler-Varianten unter Einhaltung aller Sicherheitsvorschriften und unter Beibehaltung einer einfachen Demontierbarkeit sowie einfachen Austauschbarkeit des externen Moduls bei einem Defekt und/oder nach Ablauf von dessen Lebensdauer preisgünstig anwendbar sind, ohne dass beim Austausch der zugehörige plombierte Elektrizitätszähler geöffnet werden muss. Die Elektrizitätszähler-Varianten sind dabei vorzugsweise zirka 25 verschiedene Arten von Ferraris-Zählern mit einem Baujahr, welches zwischen 1930 und 1990 liegt. Bei mindestens einer Erfindungsvariante kann ausserdem eine von drei plombierten Sicherheitsanordnungen eingespart werden.

Die genannte Aufgabe wird erfindungsgemäss durch die im Kennzeichen des Anspruchs 1 bzw. des Anspruchs 6 angegebenen Merkmale gelöst.

Vorteilhafte Ausgestaltungen der Erfindung ergeben sich aus den Unteransprüchen.

Ein Ausführungsbeispiel der Erfindung ist in der Zeichnung dargestellt und wird im folgenden näher beschrieben.

Es zeigen:
- Fig. 1: eine erste Explosionszeichnung der Montage einer erfindungsgemässen Anordnung,
- Fig. 2: eine zweite Explosionszeichnung der Montage einer erfindungsgemässen Anordnung,
- Fig. 3: eine Draufsicht einer Rückseite einer als Zwischenstück dienenden Platte,
- Fig. 4: einen Querschnitt der als Zwischenstück dienenden Platte,
- Fig. 5: eine perspektivische Darstellung der Rückseite der als Zwischenstück dienenden Platte und
- Fig. 6: eine perspektivische Darstellung einer Vorderseite der als Zwischenstück dienenden Platte.

Gleiche Bezugszahlen bezeichnen in allen Figuren der Zeichnung gleiche Teile.

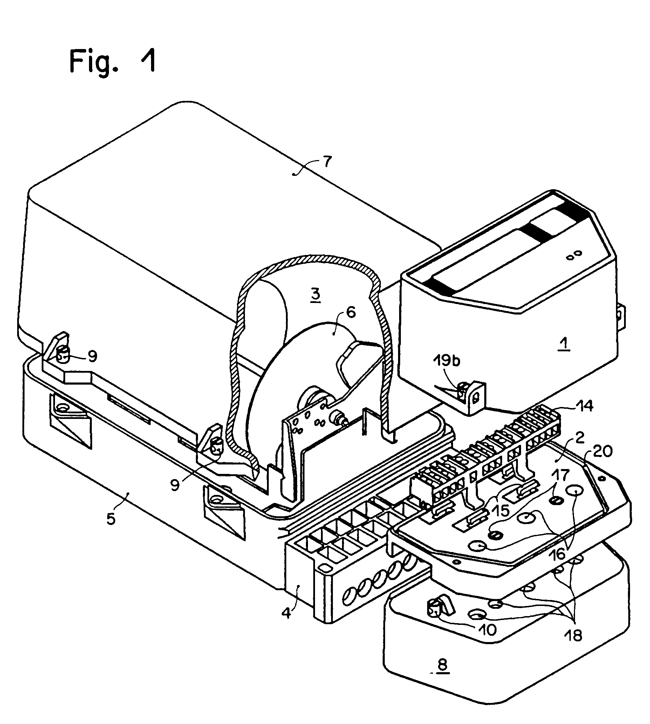

Die in der Fig. 1 dargestellte Anordnung besteht aus einem externen Modul 1, einem Zwischenstück 2 und einem Elektrizitätszähler 3.

Der Elektrizitätszähler 3 besteht in der Regel aus einem mit einer Klemmenreihe 4 versehenen Gehäuseboden 5, in dem ein Messwerk 6 montiert ist, einem Gehäusedeckel 7 und einem Klemmendeckel 8, der montiert die Klemmenreihe 4 bedeckt. Der Gehäusedeckel 7 ist mittels eines in der Fig. 1 nicht sichtbaren Scharniers und/oder plombierten Schrauben 9 auf dem Gehäuseboden 5 befestigt, mit dem zusammen er dann ein Gehäuse 5;7 bildet, in dem das Messwerk 6 enthalten ist. Der in der Fig. 1 dargestellte Elektrizitätszähler 3 ist ein Ferrari-Zähler. In diesem Fall beinhaltet das Messwerk 6 dessen drehbare Scheibe und in der Regel auch einen nicht dargestellten Impulsgeber. Alle elektrischen Anschlüsse des Messwerkes 6 sind intern im Gehäuse 5;7 elektrisch fest mit Klemmen der Klemmenreihe 4 verbunden. Alle Anschlüsse des Elektrizitätszählers 3 und des externen Moduls 1 mit der Aussenwelt, z. B. mit dem Energieversorgungsnetz, erfolgen über Klemmen der Klemmenreihe 4. Der Klemmendeckel 8 ist mit mindestens einer plombierten Befestigung 10, z. B. mit einer oder zwei plombierten Schrauben, auf die Klemmenreihe 4 und damit auf den Elektrizitätszähler 3 montiert.

Zum Ausrüsten einer Vielzahl von unterschiedlichen Elektrizitätszähler-Varianten in einer Region, z. B. in einer Altstadt einer Grossstadt, wird jeweils im erfindungsgemässen Verfahren, nach einer minimalen Bearbeitung einer Montagefläche eines auszurüstenden Elektrizitätszählers 3, das Zwischenstück 2 zwischen dem externen Modul 1 und einem zugehörigen auszurüstenden Elektrizitätszähler 3 montiert. Die minimale Bearbeitung der Montagefläche des auszurüstenden Elektrizitätszählers 3 besteht dabei darin, dass die zum Montieren des Zwischenstücks 2 dienende Montagefläche des auszurüstenden Elektrizitätszählers 3 mit mindestens einem Loch und/oder mit mindestens einem Schraubgewinde versehen wird, wobei vorzugsweise zwei Löcher bzw. zwei Schraubgewinde verwendet werden. Die auszurüstenden Elektrizitätszähler-Varianten sind vorzugsweise alte, bereits bei Kunden montierte Elektrizitätszähler. Zum Ausrüsten von einem bereits montierten Elektrizitätszähler 3 wird im erfindungsgemässen Verfahren vorzugsweise nur vorübergehend dessen Klemmendeckel 8 entfernt zwecks Bewerkstelligung von Änderungen, ohne dabei den Elektrizitätszähler 3 selber abzumontieren.

Eine erste und eine zweite Fläche des Zwischenstücks 2 sind unabhängig voneinander ausgebildet. Die erste Fläche des Zwischenstücks 2 ist jeweils räumlich an einer Montagefläche aller auszurüstenden Elektrizitätszähler-Varianten angepasst. Diese Montagefläche ist dabei vorzugsweise, wie in der Fig. 1 angenommen, eine Vorderseite des Klemmendeckels 8 des Elektrizitätszählers 3. Die zweite Fläche des Zwischenstücks 2 ist ihrerseits räumlich an einer Montagefläche des externen Moduls 1 angepasst. Das Innern des externen Moduls 1 ist nach seiner Montage auf einem zugehörigen Elektrizitätszähler 3 von Aussen unzugänglich.

In einer Anordnung zur Durchführung des erfindungsgemässen Verfahrens besitzt das Zwischenstück 2 vorzugsweise die Gestalt einer Platte. In diesem Fall ist eine erste Seite der Platte, vorzugsweise deren Rückseite, mit Hohlräumen 11, 12 und 13 versehen, die so angeordnet und dimensioniert sind, dass die Platte nach ihrer Montage mindestens teilweise bündig auf der Montagefläche des zugehörigen Elektrizitätszählers 3 aufliegt. Eine zweite Seite der Platte, vorzugsweise deren Vorderseite, ist so ausgebildet, dass das externe Modul 1 nach seiner Montage mindestens teilweise bündig auf der zweiten Seite der Platte aufliegt. Wenn die Montagefläche des auszurüstenden Elektrizitätszählers 3 eine äussere Fläche, z. B. die Vorderseite, eines Klemmendeckels 8 des Elektrizitätszählers 3 ist, dann sind vorzugsweise die Platte so ausgebildet und dimensioniert sowie die Hohlräume 11 bis 13 vorzugsweise so ausgebildet, angeordnet und dimensioniert, dass die plombierte Befestigung 10 des Klemmendeckels 8 nach der Montage der Platte unzugänglich ist und z. B. durch die Platte nach deren Montage vollständig oder teilweise abgedeckt ist. Dies ist insbesonders der Fall, wenn der Klemmendeckel 8 eine flache Vorderseite besitzt und nur mittels zweier vostehehender Schrauben befestigt ist, deren Anstand einen Wert besitzt, der zwischen 50 mm und 125 mm liegt.

Auf der zweiten Seite der Platte ist vorzugsweise eine Klemmenreihe 14 vorhanden, die z. B. durch Schrauben, Schnappverschlüsse oder andere Befestigungsmittel auf der zweiten Seite der Platte montiert ist. In der Zeichnung gilt die Annahme, dass vier Schappverschlüsse 15 vorhanden sind. Die Klemmenreihe 14 ist mittels mindestens einer nicht dargestellten elektrischen Kabelverbindung über mindestens eine in der Platte vorhandenen Durchführung 16 mit der unter dem Klemmendeckel 8 befindlichen Klemmenreihe 4 des Elektrizitätszählers 3 elektrisch verbunden. In der Zeichnung gilt die Annahme, dass drei Durchführungen 16 in der Platte vorhanden sind.

Wenn das externe Modul 1 Steckerpartien aufweist, dann sind diese vorzugsweise auf der Montageflächenseite des externen Moduls 1 vertieft im letzteren angeordnet. In diesem Fall ist die auf der Platte befindliche Klemmenreihe 14 ebenfalls mit Steckerpartien versehen, in denen das externe Modul 1 anlässlich seiner Montage steckbar ist. Das externe Modul 1 besitzt z. B. einen Boden, der mit den Steckerpartien des externen Moduls 1 versehen ist, und ein Gehäuse, welches über den Boden so weit vorsteht, dass die Steckerpartien des externen Moduls 1 sich in einem zur Montageflächenseite hin offenen Hohlraum befinden, der seitlich vom vorstehenden Teil des Gehäuses umgeben ist.

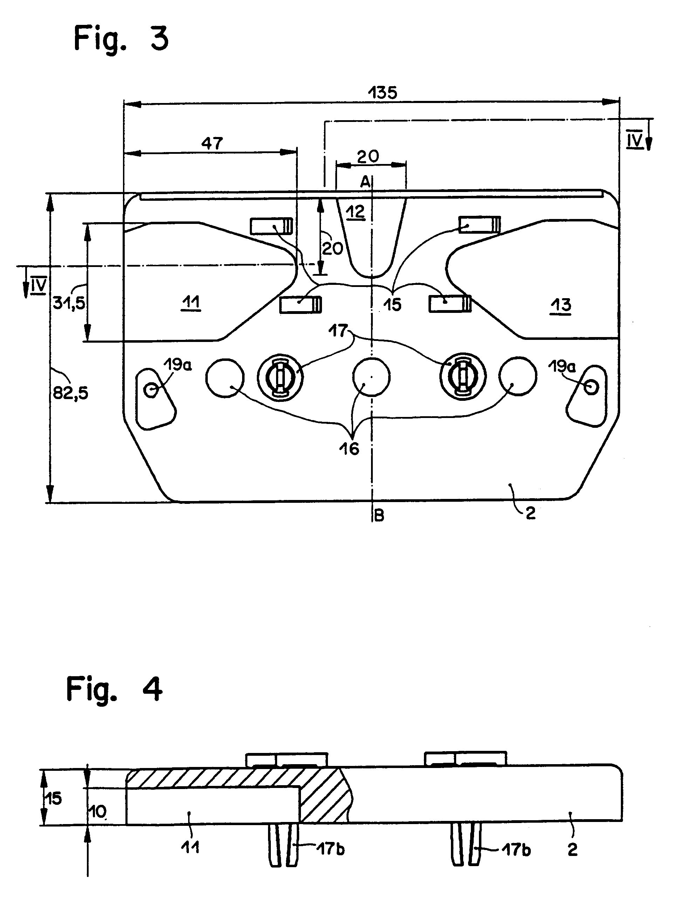

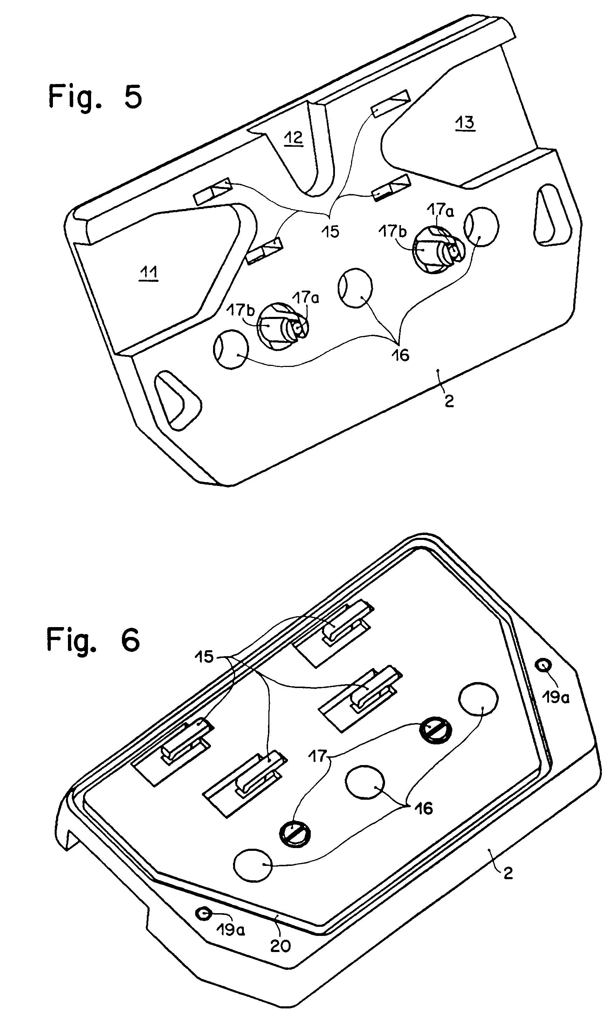

In der Fig. 6 ist eine Vorderseite und in der Fig. 5 eine Rückseite einer erfindungsgemässen Platte dargestellt, die ausserdem in der Fig. 3 und der Fig. 4 noch einmal massstabgetreu dargestellt sind. Sie besteht in der Darstellung der Fig. 3 aus einem oberen annähernd rechteckförmigen und einem unteren annähernd trapezförmigen Teil, wobei vorzugsweise alle Kanten der Draufsicht abgerundet sind. Die äusseren Abmessungen der letzteren sind vorzugsweise 135 mm x 82,5 mm. Die Platte besteht z. B. aus Kunststoff und ist z. B. annähernd 15 mm dick, wobei die Tiefe aller Hohlräume dann vorzugsweise 10 mm beträgt (siehe Fig. 4). In der Zeichnung gilt die Annahme, dass drei Hohlräume 11 bis 13 auf der Rückseite der Platte vorhanden sind, wobei in der Darstellung der Fig. 3 ein erster Hohlraum 11 auf der linken Seite, ein zweiter Hohlraum 12 an der oberen Seite und ein dritter Hohlraum 13 auf der rechten Seite jeweils der Platte angeordnet sind. Die letztere ist z. B. symmetrisch zu einer senkrecht zur Längsrichtung der Platte verlaufende Symmetrieachse AB ausgebildet. Die äusseren Abmessungen des ersten und dritten Hohlraumes 11 und 13 sind vorzugsweise parallel zur Längsrichtung der Platte 47 mm und senkrecht zur Längsrichtung der Platte 31,5 mm, während die entsprechenden äusseren Abmessungen des zweiten Hohlraumes 12 jeweils 20 mm betragen. Die Gestalt der beiden Hohlräume 11 und 13 ist auf Seite der äusseren Kante der Draufsicht annähernd rechteckförmig, während sie zum Zentrum der Platte hin annähernd dreieckförmig ist, wobei alle Kanten vorzugsweise abgerundet sind. Der zweite Hohlraum 12 ist z. B. annähernd dreieckförmig mit einer zum Zentrum der Platte hinweisenden, abgerundeten Spitze.

Die dargestellte Platte besitzt zwei Schraubverbindungen 17 zum Befestigen der Platte auf die Montagefläche des Elektrizitätszählers 3, wobei die beiden Schraubverbindungen 17 und die drei dargestellten Durchführungen 16 für Kabelverbindungen z. B. in einer Reihe nebeneinander angeordet sind. Die von der Vorderseite zugänglichen Schraubverbindungen 17 bestehen z. B. je aus einer unverlierbaren Schraube 17a, die in einer auf der Rückseite der Platte vorstehende und mit einem Schlitz versehene Kunststoffhülse 17b montiert ist (siehe Fig. 4 und Fig. 5).

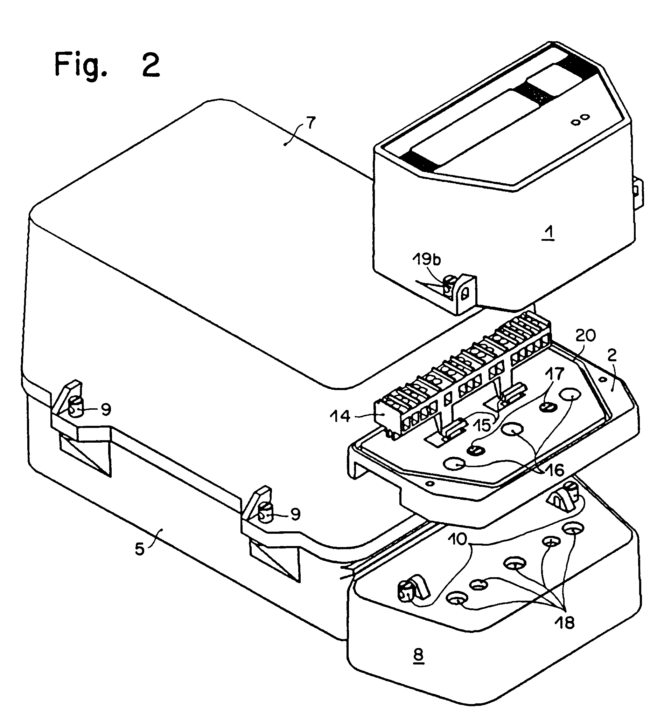

Die Platte weist ausserdem noch z. B. zwei Schraubengewinde 19a auf (siehe z. B. Fig. 6) zur Befestigung des externen Moduls 1 auf der Platte mittels zweier Schrauben 19b (siehe Fig. 1 und Fig. 2), die unverlierbar am Gehäuse des externen Moduls 1 vorhanden sind.

Um eine Hermetizität zwischen dem externen Modul 1 und der Platte zu gewährleisten, ist die letztere vorzugsweise auf ihrer Vorderseite mit einer Rille 20 versehen (siehe z. B. Fig. 6), die, mehr oder weniger parallel zum äusseren Umfang der Platte verlaufend, eine gleiche Gestalt und Abmessung besitzt wie der Umfang des über den Boden des externen Moduls 1 vorstehenden Gehäuseteils des letzteren, so dass das Gehäuseblech des externen Moduls 1 anlässlich der Montage in die Rille 20 eindringt. In der letzteren ist notfalls ein dichtender Gummi eingelegt, so dass an der Nahtstelle zwischen Modulgehäuse und Platte keine Feuchtigkeit in das Modul 1 eindringen kann. Die Rückseite des externen Moduls 1 liegt somit hermetisch und bündig auf die Vorderseite der Platte auf, so dass an dieser Stelle ebenfalls ein Personenschutz gegen elektrischen Kontakt vorhanden ist. Da das externe Modul 1 nur über die Steckerpartien mit elektrischer Energie versorgt wird, ist der Personenschutz auch bei gezogenem Modul 1 gewährleistet, weil das externe Modul 1 dann spannungslos ist.

Nachfolgend gilt die Annahme, dass die Montagefläche des Elektrizitätszählers 3 die Vorderseite von dessem Klemmendeckel 8 ist, welcher fünf Löcher 18 aufweist (siehe Fig. 1 und Fig. 2), die so angeordnet und dimensioniert sind, dass sie nach der Montage der Platte räumlich mit deren Durchführungen 16 und deren Schraubverbindungen 17 übereinstimmen.

Für die nachfolgende Beschreibung des erfindungsgemässen Verfahrens gilt die Annahme, dass ein umzurüstender alter und bei einem Kunden montierter Elektrizitätszähler 3 bereits mit einem Impulsgeber und/oder andere Zusatzbestandteile ausgerüstet ist, die für den Betrieb eines externen Moduls erforderlich sind. Falls dies noch nicht der Fall sein sollte, muss der Elektrizitätszähler 3 vorher vom Elektrizitätswerk demontiert und umgerüstet werden, wobei dann alle elektrischen Anschlüsse des Impulsgebers und/oder der Zusatzbestandteile intern im Elektrizitätszähler 3 elektrisch mit Klemmen von dessen Klemmenreihe 4 verbunden werden. Anschliessend muss dann der umgerüstete Elektrizitätszähler 3 noch bei einem von einem öffentlichen Amt für Messwesen autorisierten Prüfamt eingereicht werden zwecks Plombierung der Schrauben 9 des Gehäusedeckels 7 mit einer amtlichen Eichplombe, bevor er wieder beim Kunden montiert werden kann.

Das erfindungsgemässe Verfahren besteht dann aus folgenden zeitlich aufeinanderfolgenden Verfahrensschritten:

In einem ersten Verfahrensschritt wird der Klemmendeckel 8 entfernt ohne den plombierten Gehäusedeckel 7 zu öffnen.

In einem zweiten Verfahrensschritt wird gegebenenfalls, falls erforderlich, die externe Verdrahtung der Klemmenreihe 4 ergänzt und/oder geändert, so dass sie auch für das zu montierende externe Modul 1 verwendbar ist. Ausserdem wird eine für das externe Modul 1 bestimmte Kabelverbindung an die Klemmenreihe 4 angeschlossen.

In einem dritten Verfahrensschritt wird entweder die Montagefläche des Elektrizitätszählers 3, d. h. die Vorderseite des Klemmendeckels 8, minimal überarbeitet, indem er mit den z. B. fünf Löchern 18 versehen wird, oder der alte abmontierte Klemmendeckel 8 wird durch einen neuen, bereits überarbeiteten Klemmendeckel 8 ersetzt.

In einem vierten Verfahrensschritt wird der überarbeitete Klemmendeckel 8 mit Hilfe der Befestigung 10 montiert, wobei die für das externe Modul 1 bestimmte Kabelverbindung durch mindestens eines der Löcher 18 hindurchgeführt wird, und die Befestigung 10 notfalls mit Werkplomben versehen, falls dies erforderlich sein sollte. In einer Ausführungsvariante sind keine solche Werkplomben erforderlich, da eine als Zwischenstück 2 anschliessend montierte Platte die Befestigung 10 bedeckt und unzugänglich macht.

In einem fünften Verfahrensschritt wird die als Zwischenstück 2 dienende Platte auf die Vorderseite des Klemmendeckels 8 gesteckt und mit Hilfe der Schraubverbindungen 17 befestigt, wobei bei der Montage die für das externe Modul 1 bestimmte Kabelverbindung z. B. durch mindestens eine der Durchführungen 16 der Platte geführt wird. Anlässlich dieser Montage werden die Kunststoffhülsen 17b der Schraubverbindungen 17 in zugehörige Löcher 18 des Klemmendeckels 8 gesteckt und anschliessend die Schrauben 17a der Schraubverbindungen 17 angezogen, was dazu führt, dass zwei durch einen Schlitz getrennte Teile der Kunststoffhülse 17b auseinandergedrückt werden, so dass die Platte fest auf den Klemmendeckel 8 befestigt ist. Diese Art Befestigung hat den Vorteil, dass der Klemmendeckel 8 sowohl aus Kunststoff als auch aus einem relativ dünnen metallischen Blech bestehen kann.

In einem sechsten Verfahrensschritt wird gegebenenfalls die Klemmenreihe 14 auf die Platte mit Hilfe z. B. der Schnappverschlüsse 15 montiert und die für das externe Modul 1 bestimmte Kabelverbindung an die Klemmenreihe 14 angeschlossen.

In einem siebten Verfahrensschritt wird das externe Modul 1 mit Hilfe seiner Steckerpartien in Steckerpartien der Klemmenreihe 14 gesteckt und z. B. mittels der Schrauben 19b auf der Platte befestigt, wobei die Schrauben 19b anschliessend mittels Werkplomben versehen und gesichert werden.

## Patentansprüche

1. Verfahren zum Ausrüsten von Elektrizitatszählern (3) aus einer Vielzahl von Elektrizitätszähler-Varianten mit je einem nach dem Ausrüsten auf einem Zwischenstück (2) angeordneten externen Modul (1), dessen Inneres nach seiner Montage von aussen unzugänglich ist, mit zeitlich aufeinanderfolgend einem ersten Verfahrensschritt, in dem ein Klemmendeckel (8) eines auszurüstenden Elektrizitätszählers (3) entfernt wird, einem zweiten Verfahrensschritt, in dem, falls erforderlich, eine externe Verdrahtung einer Klemmenreihe (4) des Elektrizitätszählers (3) ergänzt und/oder geändert wird, einem sechsten Verfahrensschritt, in dem eine für das externe Modul (1) bestimmte Kabelverbindung an eine Klemmenreihe (14) des Zwischenstücks (2) angeschlossen wird und einem siebten Verfahrensschritt, in dem das externe Modul (1) mit Hilfe von ersten Steckerpartien in zweite Steckerpartien der Klemmenreihe (14) des Zwischenstücks (2) gesteckt und auf eine Vorderseite des Zwischenstücks (2) angeordnet wird, dadurch gekennzeichnet, dass nach dem ersten, bzw. falls erforderlich, nach dem zweiten und vor dem sechsten Verfahrensschritt zeitlich aufeinanderfolgend in einem dritten Verfahrensschritt eine Vorderseite des Klemmendeckels (8) minimal überarbeitet wird, in einem vierten Verfahrensschritt der Klemmendeckel (8) auf die Klemmenreihe (4) des Elektrizitätszählers (3) montiert wird sowie in einem fünften Verfahrensschritt das Zwischenstück (2) mit einer an die Vorderseite des Klemmendeckels (8) aller auszuröstenden Elektrizitätszähler-Varianten räumlich angepassten Rückseite auf die Vorderseite des Klemmendeckels (8) montiert wird.

2. Verfahren nach Anspruch 1, dadurch gekennzeichnet, dass im siebten Verfahrensschritt das externe Modul (1) auf das Zwischenstück (2) so angeordnet wird, dass seine Rückseite auf die Vorderseite des Zwischenstücks (2) aufliegt.

3. Verfahren nach Anspruch 1 oder 2, dadurch gekennzeichnet, dass die auszurüstenden Elektrizitätszähler-Varianten alte, bereits bei Kunden montierte Elektrizitätszähler (3) sind.

4. Verfahren nach Anspruch 3, dadurch gekennzeichnet, dass zum Ausrüsten von einem bereits montierten Elektrizitätszähler (3) nur vorübergegend dessen Klemmendeckel (8) entfernt wird zwecks Bewerkstelligung von Änderungen, ohne dabei den Elektrizitätszähler (3) selber abzumontieren.

5. Verfahren nach einem der Ansprüche 1 bis 4, dadurch gekennzeichnet, dass die minimale Bearbeitung des Klemmendeckels (8) des auszurüstenden Elektrizitätszählers (3) darin besteht, dass der zum Montieren des Zwischenstücks (2) dienende Klemmendeckel (8) des auszurüstenden Elektrizitätszählers (3) mit mindestens einem Loch und/oder mindestens einem Schraubgewinde versehen wird.

6. Zwischenstück zum Ausrüsten eines Elektrizitätszählers mittel eines Verfahrens nach einem der Ansprüche 1 bis 5, dadurch gekennzeichnet, dass das Zwischenstück (2) die Gestalt einer Platte besitzt, dass eine erste Seite des Zwischenstückes mit Hohlräumen (11 bis 13) versehen ist, die so angeordnet und dimensioniert sind, dass das Zwischenstück nach seiner Montage mindestens teilweise bündig auf dem Klemmendeckel (8) des zugehörigen Elektrizitätszählers (3) aufliegt, und dass eine zweite Seite des Zwischenstücks so ausgebildet ist, dass das externe Modul (1) nach seiner Montage mindestens teilweise bündig auf der zweiten Seite des Zwischenstücks aufliegt.

7. Zwischenstück nach Anspruch 6, dadurch gekennzeichnet, dass das Zwischenstück so ausgebildet und dimensioniert sowie die Hohlräume (11 bis 13) so angeordnet, ausgebildet und dimensioniert sind, dass eine plombierte Befestigung (10) des Klemmendeckels (8) nach der Montage des Zwischenstückes unzugänglich ist.

8. Zwischenstück nach Anspruch 6 oder 7, dadurch gekennzeichnet, dass auf der zweiten Seite des Zwischenstückes die Klemmenreihe (14) vorhanden ist und dass die Klemmenreihe (14) über mindestens eine in dem Zwischenstück vorhandene Durchführung (16) mit der unter dem Klemmendeckel (8) befindlichen Klemmenreihe (4) des Elektrizitätszählers (3) elektrisch verbunden ist.

9. Zwischenstück nach Anspruch 8, dadurch gekennzeichnet, dass die ersten Steckerpartien des externen Moduls (1) auf der Montageflächenseite des externen Moduls (1) vertieft im letzteren angeordnet sind.

10. Zwischenstück nach einem der Ansprüche 6 bis 9, dadurch gekennzeichnet, dass die zweite Seite des Zwischenstückes mit einer Rille (20) versehen ist, die mehr oder weniger parallel zum äusseren Umfang des Zwischenstückes verlaufend, eine gleiche Gestalt und Abmessung besitzt wie der Umfang eines über den Boden des externen Moduls (1) vorstehenden Gehäuseteils des letzteren.

## Claims

1. A method of equipping electricity meters (3) from a plurality of electricity meter variants with a respective external module (1) which is arranged on an intermediate portion (2) after the equipping operation and the interior of which is inaccessible from the outside after fitting thereof, comprising in succession in respect of time a first method step in which a terminal cover (8) of an electricity meter (3) to be so equipped is removed, a second method step in which if necessary external wiring of a terminal block (4) of the electricity meter (3) is supplemented and/or altered, a sixth method step in which a cable connection intended for the external module (1) is connected to a terminal block (14) of the intermediate portion (2), and a seventh method step in which the external module (1) is plugged by means of first plug parts into second plug parts of the terminal block (14) of the intermediate portion (2) and is arranged on the front side of the intermediate portion (2), characterised in that after the first and if necessary after the second and prior to the sixth method step in succession in respect of time in a third method step a front side of the terminal cover (8) is minimally reworked, in a fourth method step the terminal cover (8) is fitted on to the terminal block (4) of the electricity meter (3) and in a fifth method step the intermediate portion (2) with a rear side which is spatially adapted to the front side of the terminal cover (8) of all electricity meter variants to be equipped is fitted on to the front side of the terminal cover (8).

2. A method according to claim 1 characterised in that in the seventh method step the external module (1) is so arranged on the intermediate portion (2) that its rear side bears against the front side of the intermediate portion (2).

3. A method according to claim 1 or claim 2 characterised in that the electricity meter variants to be equipped are old electricity meters (3) which are already fitted at customers.

4. A method according to claim 3 characterised in that for equipping an electricity meter (3) which is already fitted in place the terminal cover (8) thereof is only temporarily removed for the purposes of making alterations without in so doing dismounting the electricity meter (3) itself.

5. A method according to one of claims 1 to 4 characterised in that the minimal working of the terminal cover (8) of the electricity meter (3) to be equipped comprises a procedure wherein the terminal cover (8), which serves to fit the intermediate portion (2), of the electricity meter (3) to be equipped, is provided with at least one hole and/or at least one screwthread.

6. An intermediate portion for equipping an electricity meter by means of a method according to one of claims 1 to 5 characterized in that the intermediate portion (2) is in the form of a plate, that a first side of the intermediate portion is provided with cavities (11 to 13) which are so arranged and are of such dimensions that the intermediate portion after fitting thereof lies at least partially flush against the terminal cover (8) of the associated electricity meter (3) and that a second side of the intermediate portion is of such a configuration that the external module (1) after fitting thereof lies at least partially flush against the second side of the intermediate portion.

7. An intermediate portion according to claim 6 characterised in that the intermediate portion is of such a configuration and of such dimensions and the cavities (11 to 13) are so arranged, of such a configuration and of such dimensions that a lead-sealed fixing (10) of the terminal cover (8) is inaccessible after fitting of the intermediate portion.

8. An intermediate portion according to claim 6 or claim 7 characterised in that the terminal block (14) is disposed on the second side of the intermediate portion and that the terminal block (14) is electrically connected by way of at least one lead-through means (16) in the intermediate portion to the terminal block (4), which is under the terminal cover (8), of the electricity meter (3).

9. An intermediate portion according to claim 8 characterised in that the first plug parts of the external module (1) are arranged on the fitting face side of the external module (1) in recessed relationship in the latter.

10. An intermediate portion according to one of claims 6 to 9 characterised in that the second side of the intermediate portion is provided with a groove (20) which, extending more or less parallel to the outer periphery of the intermediate portion, is of the same configuration and dimensions as the periphery of a housing portion of the external module (1), which housing portion projects beyond the bottom of the external module (1).

## Revendications

1. Procédé pour équiper des compteurs d'électricité (3), faisant partie d'un grand nombre de variantes de compteurs d'électricité, respectivement d'un module externe (1), disposé après l'équipement sur un adaptateur (2) et dont l'intérieur est inaccessible de l'extérieur après son montage, le procédé comportant dans une séquence temporelle une première étape opératoire dans laquelle un capot de bornes (8) est enlevé d'un compteur d'électricité (3) à équiper, une seconde étape opératoire dans laquelle, si nécessaire, un câblage externe d'une rangée de bornes (4) du compteur d'électricité (3) est complété et/ou modifié, une sixième étape opératoire dans laquelle un câblage de liaison convenant pour le module externe (1) est raccordé à une rangée de bornes (14) de l'adaptateur (2) et une septième étape opératoire dans laquelle le module externe (1) est enfiché à l'aide de premières parties d'enfichage dans des secondes parties d'enfichage de la rangée de bornes (14) de l'adaptateur (2) et est disposé sur un côté avant de l'adaptateur (2), procédé caractérisé en ce que, après la première, ou si cela est nécessaire après la seconde et avant la sixième étape opératoire, on effectue successivement, dans une troisième étape opératoire, un usinage minimal de correction d'un côté avant du capot de bornes (8), dans une quatrième étape opératoire un montage du capot de bornes (8) sur la rangée de bornes (4) du compteur d'électricité (3) et, dans une cinquième étape opératoire, un montage de l'adaptateur (2), pourvu d'un côté arrière adapté spatialement au côté avant du capot de bornes (8) de toutes les variantes de compteurs d'électricité à équiper, sur le côté avant du capot de bornes (8).

2. Procédé selon la revendication 1, caractérisé en ce que dans une septième étape opératoire, le module externe (1) est disposé sur l'adaptateur (2) de telle sorte que son côté arrière s'applique contre le côté avant de l'adaptateur (2).

3. Procédé selon la revendication 1 ou 2, caractérisé en ce que les variantes de compteurs d'électricité à équiper sont des compteurs d'électricité anciens (3), déjà installés chez des clients.

4. Procédé selon la revendication 3, caractérisé en ce que, pour un équipement d'un compteur d'électricité (3) déjà installé, on enlève seulement temporairement son capot de bornes (8) en vue de l'exécution de modifications, sans démonter alors le compteur d'électricité (3) proprement dit.

5. Procédé selon une des revendications 1 à 4, caractérisé en ce que l'usinage minimal du capot de bornes (8) du compteur d'électricité (3) à équiper consiste à pourvoir le capot de bornes (8), servant au montage de l'adaptateur (2), du compteur d'électricité (3) à équiper, d'au moins un trou et/ou d'au moins une liaison par vissage.

6. Adaptateur pour l'équipement d'un compteur d'électricité par un procédé selon une des revendications 1 à 5, caractérisé en ce que l'adaptateur (2) à la forme d'une plaque, en ce qu'un premier côté de l'adaptateur est pourvu de creux (11 à 13), qui sont disposés et dimensionnés de telle sorte que l'adaptateur vienne s'appliquer, après son montage, au moins en partie étroitement contre le capot de bornes (8) du compteur d'électricité (3) associé et en ce qu'un second côté de l'adaptateur est agencé de telle sorte que le module externe (1) vienne s'appliquer, après son montage, au moins en partie étroitement contre le second côté de l'adaptateur.

7. Adaptateur selon la revendication 6, caractérisé en ce que l'adaptateur est agencé et dimensionné, et les creux (11 à 13) sont disposés, agencés et dimensionnés, de telle sorte qu'une fixation plombée (10) du capot de bornes (8) soit inaccessible après le montage de l'adaptateur.

8. Adaptateur selon la revendication 6 ou 7, caractérisé en ce que la rangée de bornes (14) est disposée sur le second côté de l'adaptateur et en ce que cette rangée de bornes (14) est reliée électriquement, par l'intermédiaire d'au moins un passage (16) existant dans l'adaptateur, avec la rangée de bornes (4) du compteur d'électricité (3) située en-dessous du capot de bornes (8).

9. Adaptateur selon la revendication 8, caractérisé en ce que les premières parties d'enfichage sont disposées, sur le côté de la surface de montage du module externe (1), en creux dans ce dernier.

10. Adaptateur selon une des revendications 6 à 9, caractérisé en ce que le second côté de l'adaptateur est pourvu d'une rainure (20), qui est orientée plus ou moins parallèlement au pourtour extérieur de l'adaptateur et qui a une forme et des dimensions identiques au pourtour d'une partie de carter du module externe (1) faisant saillie du fond de ce module.
